Europäisches Patentamt

European Patent Office

Office européen des brevets

(19)

(11) **EP 0 673 113 B1**

(12) **FASCICULE DE BREVET EUROPEEN**

(45) Date de publication et mention
de la délivrance du brevet:
**25.08.1999 Bulletin 1999/34**

(51) Int Cl.⁶: **H03G 3/32**, G06F 15/80

(21) Numéro de dépôt: **95200554.4**

(22) Date de dépôt: **07.03.1995**

(54) **Système de caractérisation de sources de signaux**

Signalquellencharakterisiersystem

System for characterization of signal sources

(84) Etats contractants désignés:
**DE FR GB**

(30) Priorité: **16.03.1994 FR 9403078**

(43) Date de publication de la demande:
**20.09.1995 Bulletin 1995/38**

(73) Titulaires:
• **LABORATOIRES D'ELECTRONIQUE PHILIPS
S.A.S.
94450 Limeil-Brévannes (FR)**
Etats contractants désignés:
**FR**
• **Koninklijke Philips Electronics N.V.
5621 BA Eindhoven (NL)**
Etats contractants désignés:
**DE GB**

(72) Inventeur: **Deville, Yannick
F-75008 Paris (FR)**

(74) Mandataire: **Landousy, Christian
Société Civile S.P.I.D.
156, Boulevard Haussmann
75008 Paris (FR)**

(56) Documents cités:
**EP-A- 0 123 349        WO-A-91/02324
FR-A- 2 679 083        GB-A- 2 257 317
US-A- 4 754 486**

## Description

L'invention concerne un système de caractérisation de sources qui, à partir de premiers signaux E(t) formés par mélange linéaire convolutif de signaux primaires X(t) issus respectivement de sources de signaux primaires, délivre au moins un second signal caractérisant respectivement au moins un signal primaire X(t), le système comprenant des moyens de séparation de sources.

Elle concerne également l'application d'un tel système au contrôle d'appareils d'émission et/ou de réception de signaux électriques, sonores, électromagnétiques. Il peut s'agir par exemple d'un autoradio, d'un téléphone mains libres.

On connaît la technique de séparation de signaux primaires issus de sources indépendantes qui consiste à traiter des mélanges de signaux primaires pour en séparer isolément chaque signal primaire. Ladite technique s'applique à des signaux primaires qui ne sont disponibles que sous la forme desdits mélanges. Il peut s'agir de mélanges linéaires convolutifs généraux. Les mélanges peuvent avoir des origines diverses. Ils peuvent être engendrés par des mécanismes de propagation des signaux primaires et/ou par des mécanismes de superposition de signaux de plusieurs sources ou d'autres causes.

Dans le cas général, la technique de séparation opère en aveugle c'est-à-dire que les sources sont supposées inconnues, indépendantes avec des mélanges inconnus. Pour cela on détecte plusieurs échantillons desdits mélanges à partir desquels la mise en oeuvre d'algorithmes de séparation permet de restituer un ou plusieurs des signaux primaires d'origine.

Une telle technique est par exemple connue du document "Blind separation of sources", C. JUTTEN, J. HERAULT, Signal processing 24 (1991), pages 1-10.

Ce document décrit des moyens de séparation de sources comprenant un réseau de neurones qui reçoit en entrée plusieurs composantes des signaux de mélanges E(t) et qui restitue en sortie les signaux primaires isolés. Le réseau de neurones opère de manière récursive pour calculer les coefficients synaptiques à l'aide d'un algorithme adaptatif. Il est possible de traiter ainsi des mélanges linéaires convolutifs instantanés c'est-à-dire pour lesquels à chaque instant, chaque signal E(t) est une combinaison linéaire à coefficients réels, fixes ou lentement variables, des valeurs des signaux primaires X(t) au même instant. Le système s'adapte continûment aux variations des mélanges. On connaît également le document "New algorithms for separation of sources" de C. JUTTEN et H.L. NGUYEN THI, Congrès Européen de Mathématiques 2-3 juillet 1991 PARIS (France) qui concerne les mélanges linéaires convolutifs généraux. Mais un tel système présente l'inconvénient que pour isoler, en aveugle, toutes les sources primaires des mélanges, il faut disposer d'une puissance de calcul importante. Ceci peut constituer un handicap dans le cas d'applications liées à la grande diffusion. De plus, il apparaît des problèmes de précision ou de stabilité des sources séparées en sortie.

Le but de l'invention est donc de réduire cette puissance de calcul en prenant en compte les spécificités des applications qui utilisent une telle séparation de sources.

Ce but est atteint avec un système de caractérisation de sources qui comprend des moyens de prétraitement placés devant les moyens de séparation de sources, les moyens de prétraitement effectuant un prétraitement des signaux E(t) en déterminant au moins une grandeur caractéristique des signaux E(t), grandeur délivrée selon des troisièmes signaux I(t, p) formés de combinaisons linéaires à coefficients fixes ou lentement variables, de grandeurs caractéristiques de même nature des signaux primaires X(t).

Ainsi, en prétraitant les signaux E(t) de cette manière, on simplifie considérablement les moyens de séparation de sources qui n'ont à traiter que des combinaisons linéaires de grandeurs caractéristiques de signaux primaires c'est-à-dire des mélanges linéaires convolutifs instantanés. De la sorte, on obtient en sortie, non pas les sources X(t) séparées, mais une ou plusieurs grandeurs caractéristiques les caractérisant. Pour beaucoup d'applications, il est en effet suffisant de connaître seulement ces grandeurs caractéristiques. Celles-ci peuvent faire l'objet d'un traitement subséquent pour obtenir, si nécessaire, les sources séparées en sortie.

Cette grandeur caractéristique peut être : une énergie moyenne, une densité spectrale, une fonction d'autocorrélation ou d'autres grandeurs. Ceci est très intéressant lorsque l'on désire par exemple soit asservir la puissance de sortie d'un appareillage tel qu'un autoradio soit détecter la voix d'un utilisateur d'un téléphone mains libres pour valider la prise en compte des informations de sa voix.

Il est bien évidemment possible d'étendre le système pour délivrer soit plusieurs signaux F(t) pour plusieurs grandeurs caractéristiques pour un même signal primaire X(t), soit plusieurs signaux F(t) pour une grandeur caractéristique, identique ou non, concernant plusieurs signaux primaires X(t).

Pour certaines grandeurs caractéristiques telles qu'une densité spectrale d'un signal, il est possible de compléter le prétraitement par un post-traitement pour transformer une grandeur caractéristique calculée en une autre grandeur caractéristique. Dans ce cas, selon l'invention, on dispose de moyens de post-traitement en sortie des moyens de séparation de sources. En combinant le prétraitement effectué par les moyens de prétraitement et le post-traitement effectué par les moyens de post-traitement, il est possible de déterminer des densités spectrales pour un ou plusieurs signaux primaires ou d'autres grandeurs caractéristiques.

Ces différents aspects de l'invention et d'autres encore seront apparents et élucidés à partir des modes de réalisation décrits ci-après.

L'invention sera mieux comprise à l'aide des figures suivantes données à titre d'exemples non limitatifs qui représentent :

Figure 1 : un schéma-bloc d'un système de caractérisation de sources muni de moyens de prétraitement.

Figure 2 : un système de caractérisation de sources muni de moyens de commandes pour rétroagir sur les sources de signaux primaires.

Figure 3 : un exemple de schéma d'une partie des moyens de prétraitement pour la détermination de l'énergie moyenne d'un signal.

Figure 4 : un exemple de schéma d'une partie des moyens de prétraitement pour la détermination de fonctions d'autocorrélation.

Figure 5 : un schéma-bloc d'un système de caractérisation de sources muni de moyens de prétraitement et de moyens de post-traitement.

Figure 6 : un schéma analogue à celui de la figure 3 avec des moyens de filtrage pour traiter des mélanges convolutifs généraux.

On distingue plusieurs types de signaux E(t) selon la nature des mélanges qui leur ont donné naissance. Des mélanges linéaires convolutifs généraux engendrent des signaux génériques $E_i(t)$ tels que :

$$(1) \qquad E_i(t) = \sum_j c_{ij}(t) * X_j(t)$$

où $c_{ij}(t)$ sont les réponses impulsionnelles des filtres de mélange et où le signe (*) représente un produit de convolution.

Parmi ces mélanges généraux, il existe une famille de mélanges pour lesquels la propagation d'un signal X(t) quelconque se fait avec un retard de propagation θ fixe et avec une atténuation $1/\alpha_{ij}$ constante. Ceci correspond en particulier à la propagation des ondes sonores dans l'air libre.

Les signaux génériques $E_i(t)$ sont alors du type :

$$(2) \qquad E_i(t) = \sum_j \alpha_{ij} . X_j(t-\theta_{ij})$$

où $\theta_{ij}$ sont des constantes définissant un retard de propagation et où le signe (.) représente une multiplication classique. Ce sont des mélanges linéaires convolutifs à retard fixe non nul.

A l'intérieur de cette famille, il existe une sous-famille de mélanges pour lesquels le retard de propagation $\theta_{ij}$ sont nuls. Les signaux génériques $E_i(t)$ sont alors du type :

$$(3) \qquad E_i(t) = \sum_j a_{ij} . X_j(t)$$

où $a_{ij}$ sont des coefficients fixes ou lentement variables (qui peuvent être différents des coefficients $\alpha_{ij}$). Ce sont des mélanges linéaires instantanés ou linéaires convolutifs à retard nul.

Le document cité de C. JUTTEN et J. HERAULT concerne des signaux conformes à l'équation (3). L'invention concerne des signaux des deux autres types.

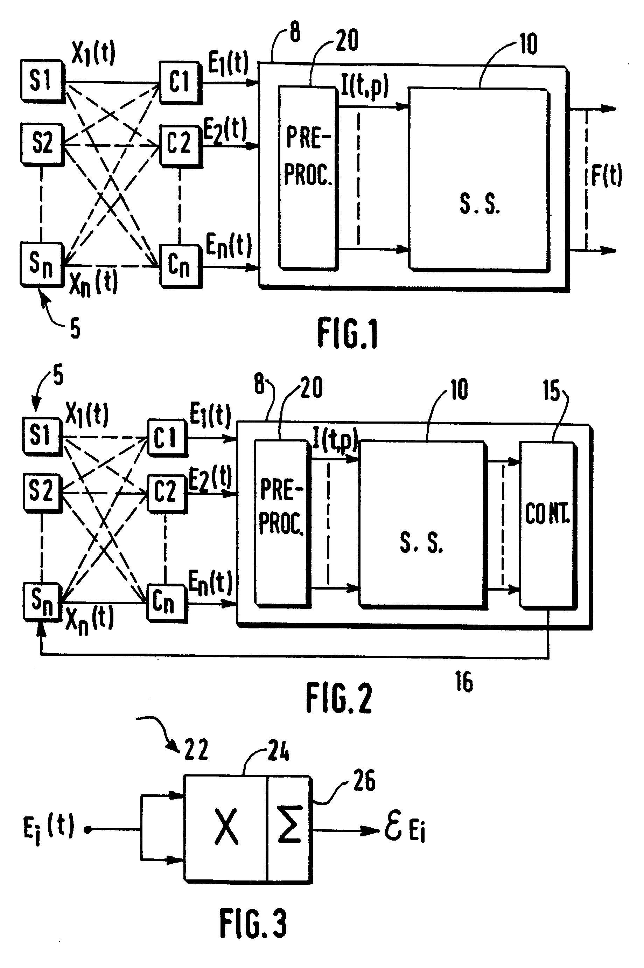

A titre d'exemple, considérons le cas du contrôle du volume sonore d'un autoradio placé dans un véhicule. L'autoradio dispose de moyens (non représentés) sur lesquels on peut agir pour contrôler le volume sonore délivré par l'autoradio en fonction des sources sonores ambiantes. Ainsi lorsque le bruit ambiant augmente (vitres ouvertes, vitesse accrue, bruits de roulement...), il est alors souhaitable d'accroître la puissance sonore délivrée par l'autoradio. Ceci n'est plus le cas lorsque les sources sonores ambiantes sont formées par la voix des passagers. Le problème posé est alors non pas d'augmenter mais de diminuer ce volume sonore lorsque des passagers parlent. Il faut donc pouvoir identifier les voix des passagers. Sur la figure 1 sont représentées les sources 5 primaires S1 à Sn constituées par exemple par les voix des passagers, par des sources de bruits divers (moteur, carrosserie, circulation d'air par les fenêtres, etc) et par l'autoradio lui-même. Pour identifier les voix, on place des capteurs C1 - Cn, par exemple des microphones, à l'intérieur de l'habitacle. Un capteur peut être une prise directe du son émis par le haut-parleur. Les microphones détectent des premiers signaux $E_1(t)$ à $E_n(t)$ issus de mélanges de signaux primaires $X_1(t)$ à $X_n(t)$ délivrés

par les sources S1 à Sn.

Les mélanges qui se font à l'intérieur de l'habitacle peuvent être considérés comme étant directement liés à la propagation de signaux sonores dans l'air. En première approximation, ces mélanges peuvent être caractérisés par un coefficient d'atténuation non nul et une constante de temps de propagation non nulle propres à chaque source. Les signaux $E_i(t)$ détectés par les microphones peuvent être définis par l'expression :

$$(4) \qquad E_i(t) = \sum_{j=1}^{n} \alpha_{ij}.X_j(t - \theta_{ij})$$

dans laquelle :

i est un indice courant d'un microphone

j est un indice courant d'une source

$1/\alpha_{ij}$, $\theta_{ij}$ sont respectivement des coefficients

d'atténuation et des constantes de temps de propagation propres à la propagation de la source $S_j$ vers le microphone $E_i$.

Selon l'invention, les signaux $E_i(t)$ entrent dans le système 8 de caractérisation de sources qui comprend des moyens 20 de prétraitement suivis de moyens 10 de séparation de sources.

Des moyens de séparation de sources aptes à séparer des mélanges linéaires instantanés de signaux, c'est-à-dire des mélanges pour lesquels les termes $\theta_{ij}$ sont tous nuls (équation 3), sont beaucoup plus simples et donc moins onéreux à réaliser que des moyens de séparation de sources aptes à séparer des mélanges linéaires convolutifs à retards non nuls conformes à l'équation 2. Les moyens pour traiter les mélanges linéaires instantanés peuvent être ceux décrits dans le document cité de C. JUTTEN et J. HERAULT.

Il existe un cas particulier pour lequel il y a seulement deux sources S1 et S2 et deux signaux mesurés E1 (t) et E2(t) dont l'un E1(t) représente un mélange des signaux des sources et l'autre E2(t) est un signal pur (ou considéré comme tel) en provenance directe d'une des sources. Dans ce cas, les moyens de séparation de sources 10 peuvent se réduire à un dispositif de filtrage adaptatif opérant une soustraction du signal pur de l'autre signal après pondération adaptative des signaux.

On peut généraliser au cas où il existe un signal pur et plusieurs signaux mélangés qui renferment le signal pur.

En pratique l'existence d'un signal pur apparaît dans le cas d'un autoradio pour lequel le signal pur est directement prélevé en sortie avant son émission par le haut-parleur.

Selon l'invention, on choisit d'utiliser des moyens (10) de séparation de sources aptes à séparer des mélanges linéaires instantanés de signaux devant lesquels on dispose des moyens 20 de prétraitement qui transforment des mélanges linéaires à retards non nuls formés par les premiers signaux $E_i(t)$ afin d'obtenir lesdites combinaisons linéaires formées par les troisièmes signaux $I_i(t, p)$.Ici, t représente le temps et p un paramètre significatif pour la grandeur caractéristique concernée (par exemple p est une fréquence). Le paramètre p est inutile dans le cas où la grandeur caractéristique est une énergie moyenne.

La structure des moyens 20 de prétraitement dépend de la grandeur caractéristique des signaux primaires X(t) que l'on veut identifier. Cette grandeur peut être :

- l'énergie moyenne d'un signal primaire X(t) de une ou de plusieurs sources. C'est dans ce cas une grandeur caractéristique globale déterminée sur une durée donnée, pour des intervalles de temps successifs,
- une fonction d'autocorrélation d'un signal primaire X(t) ou de plusieurs signaux primaires X(t), déterminée sur une durée donnée, sur un ou plusieurs intervalles de temps successifs,
- une densité spectrale donnant la répartition spectrale d'un signal primaire X(t) ou de plusieurs signaux primaires X(t) sur une durée déterminée, sur un ou plusieurs intervalles de temps successifs.

L'homme du métier peut évidemment mettre en oeuvre l'invention pour d'autres grandeurs caractéristiques sans s'écarter de l'objet de l'invention.

Pour mettre en oeuvre l'invention, on élimine au préalable les composantes continues des signaux E(t) par exemple en les faisant passer à travers un filtre passe-bas. On obtient ainsi des signaux E(t) à valeur moyenne nulle comme dans le document de C. JUTTEN et J. HERAULT.

A titre d'exemple considérons le cas de la détermination de l'énergie moyenne d'un signal primaire X(t). Pour cela, les moyens 20 de prétraitement calculent l'énergie moyenne des signaux $E_i(t)$. Pour le signal $E_1(t)$, cette énergie moyenne est déterminée sur une durée $\delta$ et à partir d'un instant t = $T_o$ telle que :

$$(5) \qquad \varepsilon_{E1}(T_o, \delta) = \sum_{t=T_o}^{T_o+\delta} E_1^2(t)$$

Si on considère le cas de deux sources S1 et S2 avec des mélanges conformes à l'équation (2), on peut écrire pour le signal mesuré par le capteur C1 :

$$E1(t) = \alpha_{11}.X_1(t-\theta_{11}) + \alpha_{12}\, X_2(t-\theta_{12})$$

L'énergie moyenne s'exprime par :

$$\varepsilon_{E1}(T_o, \delta) \simeq \alpha_{11}^2.\varepsilon_{X1}(T_o, \delta) + \alpha_{12}^2.\varepsilon_{X2}(T_o, \delta),$$

en considérant le cas de sources $X_1$ et $X_2$ non corrélées et en choisissant $\delta$ tel que :

$$\theta_{11}, \theta_{12} << \delta.$$

On observe que les termes de retard $\theta_{11}, \theta_{12}$ ont disparu et que le terme $\varepsilon_{E1}$ est un mélange linéaire à coefficients fixes ou lentement variables et à retard nul des énergies moyennes des sources S1 et S2.

En calculant les énergies moyennes des signaux $E_i(t)$, on obtient ainsi des signaux $I(t, p) = \varepsilon_{Ei}(T_o, \delta)$ à partir desquels il est possible de séparer les énergies des signaux primaires.

La figure 3 représente un élément 22 constitutif des moyens 20 de prétraitement. Cet élément 22 comprend des moyens 24 pour multiplier le signal $E_i(t)$ par lui-même, suivis de moyens 26 pour accumuler les résultats de la multiplication sur la durée $\delta$. En sortie, on obtient l'énergie moyenne $\varepsilon_{Ei}$ correspondant au signal $E_i(t)$.

Le schéma de la figure 3 est représentatif d'une réalisation pour un traitement numérique du signal. Il est possible d'atteindre le même résultat avec une réalisation analogique, par exemple en intégrant à l'aide de capacités le signal redressé, sans s'écarter du cadre de l'invention.

Les moyens 20 de prétraitement sont alors formés de plusieurs éléments 22, chacun étant affecté à un signal $E_i(t)$. On peut opérer un multiplexage temporel. En sortie, on obtient donc une pluralité d'énergies moyennes $\varepsilon_{Ei}$ correspondant à chaque signal $E_i(t)$. Toutes ces énergies moyennes $\varepsilon_{Ei}$ sont introduites dans les moyens 10 de séparation de sources comme cela est représenté sur la figure 1. Ceux-ci effectuent la séparation des sources et délivrent en sortie des signaux $F_i(t)$ qui dans ce cas sont les énergies moyennes de chacun des signaux primaires $X_i(t)$ sur les intervalles de temps successifs considérés.

Préférentiellement les moyens 10 de séparation de sources comprennent un réseau de neurones. C'est par exemple celui décrit dans le document cité de C. JUTTEN et J. HERAULT. Selon la technique connue de l'homme du métier, le fonctionnement d'un réseau de neurones s'effectue en deux phases :

- une phase d'apprentissage au cours de laquelle il apprend à effectuer une tâche,
- et une phase de résolution au cours de laquelle il met en oeuvre les données apprises pour déterminer les résultats correspondants à des valeurs courantes.

Ces techniques d'apprentissage sont connues et ne seront pas développées ici. Il suffit de savoir qu'elles consistent à fournir en entrée des exemples et à modifier les caractéristiques du réseau de neurones (essentiellement ses coefficients synaptiques) pour que celui-ci délivre en sortie les résultats attendus correspondants aux exemples. On utilise un apprentissage dit "non supervisé", c'est-à-dire que sur la base d'exemple, on applique un algorithme d'adaptation des coefficients synaptiques de telle sorte que les sorties du réseau de neurones délivrent des seconds signaux F(t) indépendants les uns des autres. Un tel apprentissage est connu de l'homme du métier.

Avec la configuration de coefficients synaptiques ainsi déterminée, le réseau de neurone est alors utilisé avec des données d'entrée nouvelles. Il est ainsi apte à déterminer des résultats dépendant des données d'entrée nouvelles pour la fonction qu'il a apprise à réaliser. Pour permettre au système d'effectuer en continu la caractérisation des sources en s'adaptant aux variations continuelles des mélanges, l'apprentissage est effectué de manière répétée pour une mise à jour des coefficients synaptiques adaptés à caractériser les nouveaux mélanges.

On fournit en entrée des signaux $E_i(t)$ mesurés correspondant à des sources primaires $X_i(t)$ de caractéristiques inconnues, et les moyens 10 délivrent les mesures de ces caractéristiques inconnues (ici les énergies moyennes).

Les propriétés caractéristiques des signaux primaires X(t) que l'on désire mesurer sont déterminées sur des intervalles successifs de temps de durée δ. Sur chaque intervalle, il peut s' agir :

- pour l'énergie moyenne, d'une valeur unique,
- pour la détermination de la fonction d'autocorrélation, d'une suite de valeurs obtenues en comparant un signal avec lui-même à des instants espacés de décalages temporels $\tau$,

    - pour la détermination des densités spectrales, d'une pluralité de valeurs déterminées à différentes fréquences.

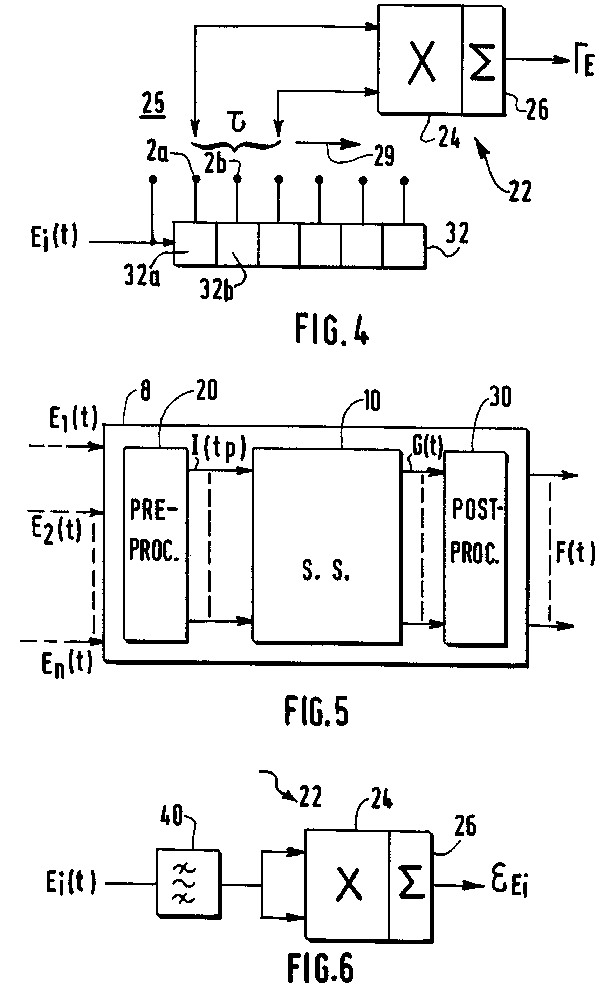

A titre d'exemple considérons le cas où on désire déterminer des fonctions d'autocorrélation $\Gamma(\tau)$ des signaux primaires $X_i(t)$ avec $\Gamma_{X_i}(\tau) = \Sigma\, X_i(t)\, .\, X_i(t+\tau)$. Pour cela les moyens 20 de prétraitement déterminent les fonctions d'autocorrélation des signaux $E_i(t)$ tel que $\Gamma_{E_i}(\tau) = \Sigma E_i(t).E_i(t+\tau)$. Les moyens 20 sont formés de blocs 25 de prétraitement tels que celui représenté sur la figure 4. Il y a autant de blocs 25 qu'il y a de signaux E(t) à traiter. On peut utiliser également un multiplexage temporel. Pour effectuer la corrélation d'un signal E(t) avec lui-même, on introduit le signal E(t) dans des moyens 32 d'acquisition qui prélèvent, à une cadence déterminée (durée D), des échantillons successifs du signal E(t). Il peut s'agir d'une mémoire formée entre autres d'éléments mémoire 32a, 32b dans lesquels on stocke une suite d'échantillons. On donne successivement au décalage $\tau$ des valeurs D, 2D, 3D et ainsi de suite. Les échantillons, espacés d'une durée D, par exemple en sortie 2a, 2b des éléments mémoire 32a, 32b sont introduits dans les moyens de traitement 22 déjà décrits pour déterminer des valeurs E(t).E (t+D). En effectuant un adressage glissant (flèche 29) de la mémoire, on détermine une valeur de la fonction d'autocorrélation $\Gamma_E$ pour la totalité du signal E(t) concerné correspondant à $\tau = D$. D'autres valeurs de la fonction d'autocorrélation pour un décalage 2D sont également calculées de la même manière avec un adressage glissant, et ainsi de suite pour d'autres décalages 3D, 4D.... Toutes ces valeurs d'autocorrélation constituent la fonction d'autocorrélation.

Il est bien évident pour l'homme du métier que les moyens 32 d'acquisition peuvent avoir une structure différente de celle de la figure 4 sans sortir du cadre de l'invention. En sortie de l'élément 22, on obtient la fonction d'autocorrélation $\Gamma_E$ correspondant au signal E(t)

$$\Gamma_{E_i}(\tau) = \Sigma\, E_i(t).\, E_i(t+\tau)$$

Les différents signaux E(t) de la figure 1 sont ainsi traités de la même manière pour fournir des fonctions d'autocorrélation $\Gamma_E$ pour chaque signal E(t). Les signaux $I(t, p)$ de la figure 1 sont alors les fonctions d'autocorrélation $\Gamma_E$. En appliquant les mêmes principes que cela a été décrit dans le cas des énergies moyennes, les moyens 10 de séparation de sources apprennent, sur la base d'exemples, à calculer des fonctions d'autocorrélation $\Gamma_X$ correspondant à chacune des sources.

En limitant l'exemple à deux sources S1 et S2, on peut écrire :

$$E1(t) = \alpha_{11}.X_1(t-\theta_{11}) + \alpha_{12}\, X_2(t-\theta_{12})$$

$$E2(t) = \alpha_{21}.X_1(t-\theta_{21}) + \alpha_{22}\, X_2(t-\theta_{22})$$

ce qui donne les fonctions d'autocorrélation $\Gamma_E$ telles que

$$\Gamma_{E1}(\tau) = \alpha_{11}^2.\Gamma_{X1}(\tau) + \alpha_{12}^2.\Gamma_{X2}(\tau)$$

$$\Gamma_{E2}(\tau) = \alpha_{21}^2.\Gamma_{X1}(\tau) + \alpha_{22}^2.\Gamma_{X2}(\tau)$$

Les moyens 10 de séparation de sources en déduisent les fonctions d'autocorrélation $\Gamma_X$ des signaux de sources telles que :

$$\Gamma_X(\tau) = \Sigma\, X(t)\, .X(t+\tau)$$

Lorsque le système 8 détermine les fonctions d'autocorrélation des signaux primaires X(t), il est également possible d'en déduire les énergies. Pour cela, il suffit de sélectionner sur la figure 4 un retard $\tau=o$ pour lequel on obtient en sortie les valeurs de $\Gamma_X(0)$ qui sont égales aux énergies.

Ce mode de fonctionnement est plus rapide que le calcul des énergies précédemment exposé car il permet de réaliser l'apprentissage du système de caractérisation de sources sur un unique intervalle de temps et non pas sur une suite d'intervalles de temps. Néanmoins les moyens matériels mis en oeuvre sont plus importants.

Selon un autre exemple, les signaux $I(t, p)$ peuvent être des signaux représentant des densités spectrales. Dans ce cas, les moyens 20 de prétraitement

- calculent les fonctions d'autocorrélation puis opèrent une transformation de Fourier pour chaque signal E(t) et délivrent des signaux I(t, f) où f est la fréquence,
- ou opèrent une transformation de Fourier (par exemple une transformation rapide) puis calculent le carré du module de la transformée de Fourier déterminée.

Tous les signaux I(t, f) issus des signaux E(t) et déterminés pour la même fréquence f sont traités dans les moyens 10 de séparation de sources comme cela a été décrit précédemment. En sortie les signaux F(t) représentent dans ce cas les densités spectrales $D_X$ correspondant aux sources S pour la fréquence f.

En opérant, successivement à différentes fréquences f, il est possible de déterminer une fonction de densité spectrale pour une ou plusieurs sources en combinant les valeurs de densité spectrale déterminées pour une même source à ces différentes fréquences.

Les signaux de sortie des moyens 20 de prétraitement qui peuvent être, comme cela vient d'être décrit, des énergies moyennes, des fonctions d'autocorrélation, des densités spectrales ou autres peuvent être ensuite utilisés pour agir sur une ou plusieurs sources S1 - Sn.

Ainsi lorsque, dans le cas d'un autoradio dans une voiture, on a déterminé l'énergie moyenne d'une source S1, le bruit par exemple, il est possible de contrôler l'amplificateur de sortie de l'autoradio d'après les énergies moyennes mesurées. De même, une détection d'une source S2 constituée d'une voix d'un locuteur, va permettre d'abaisser le son de l'autoradio ou de contrôler le fonctionnement du téléphone, par exemple en effectuant la transmission des numéros prononcés par un locuteur ou de valider la transmission de la parole uniquement lorsque celle-ci est détectée.

Lorsque la grandeur caractéristique correspond à des densités spectrales, il est possible d'intervenir sur le contrôle de tonalité ou sur l'égaliseur de l'autoradio.

Evidemment ce qui vient d'être exposé reste valable, s il s'agit d'appareils de reproduction sonore autres auxquels on associe des capteurs ou des détecteurs des signaux E(t).

Pour réaliser ce contrôle, le système 8 de caractérisation de sources est muni de moyens 15 de commande (figure 2) qui déterminent l'action à entreprendre en liaison avec l'application concernée. Ainsi une détection de voix dans l'habitacle de la voiture peut conduire à entreprendre une action sur le volume sonore de l'autoradio. Les moyens 15 de commande délivrent pour cela une commande 16 qui intervient sur la source appropriée.

Pour d'autres applications, il peut également s'agir d'autres sources S1 - Sn telles que des sources hertziennes, les mélanges s'opérant par la transmission par voie hertzienne. Dans ce cas, les signaux E(t) peuvent être détectés par des capteurs formés par exemple par des antennes. Le traitement effectué par le système de caractérisation de sources reste analogue.

Dans d'autres cas encore, les sources sont localisées à l'intérieur d'un même appareillage, les signaux X(t) étant véhiculés par des fils, les mélanges s'opérant alors par diaphonie entre fils. Dans ce cas, les signaux E(t) ne sont pas obtenus par des capteurs C1 à Cn.

Pour déterminer les densités spectrales $D_X(V)$, il est également possible de combiner le prétraitement 20 décrit pour le calcul des fonctions d'autocorrélation avec un postraitement 30 réalisé en sortie des moyens 10 de séparation de sources. La figure 5 correspond à ce genre de traitement. Les moyens 20 de prétraitement suivis par les moyens 10 de séparation de sources déterminent les fonctions d'autocorrélation $\Gamma_{X_i}(t)$, des moyens de posttraitement 30 placés en sortie leur appliquant une transformation de Fourier.

L'invention vient d'être décrite dans le cas de signaux linéairement convolutifs contenant des termes de gains et des termes de retards purs définis par l'équation (2).

Il est possible d'appliquer l'invention aux cas plus généraux des mélanges convolutifs c'est-à-dire ceux définis par l'équation (1).

Pour réduire le cas général au cas particulier de l'équation (2), décrit précédemment, on effectue le traitement sur des signaux E(t) dont la bande de fréquences a été préalablement limitée. Pour cela, les moyens 20 de prétraitement disposent en entrée de filtres 40 identiques (figure 6) qui limitent chaque signal $E_i(t)$ à une bande réduite de fréquences. Le traitement décrit préalablement reste inchangé mais les résultats obtenus concernent alors non pas les signaux primaires X(t) mais des versions filtrées de leurs mélanges. Néanmoins, ces résultats sont suffisants pour effectuer la caractérisation de sources même en présence de mélanges convolutifs quelconques. Dans le cas, par exemple, du calcul des énergies moyenne ou dans celui des densités spectrales, il est possible en sortie de combiner les signaux se rapportant à des bandes de fréquences successives pour obtenir ces grandeurs caractéristiques sur la totalité du spectre de fréquences.

**Revendications**

1. Système (8) de caractérisation de sources qui, à partir de premiers signaux E(t) formés par mélange linéaire convolutif de signaux primaires X(t) issus respectivement de sources (5) de signaux primaires, délivre au moins un second signal (F) caractérisant respectivement au moins un signal primaire X(t), le système comprenant des moyens (10) de séparation de sources caractérisé en ce qu'il comprend des moyens (20) de prétraitement placés devant les moyens (10) de séparation de sources, les moyens de prétraitement effectuant un prétraitement des signaux E(t) en déterminant au moins une grandeur caractéristique des signaux E(t), grandeur délivrée selon des troisièmes signaux I(t, p) formés de combinaisons linéaires à coefficients fixes ou lentement variables de grandeurs caractéristiques de même nature des signaux primaires X(t).

2. Système selon la revendication 1 caractérisé en ce que la grandeur caractéristique est : une énergie moyenne, une densité spectrale, une fonction d'autocorrélation.

3. Système selon une des revendications 1 ou 2 caractérisé en ce qu'il comprend des moyens (30) de post-traitement placés en sortie des moyens (10) de séparation de sources pour effectuer un post-traitement de quatrièmes signaux G(t) délivrés par les moyens (10) de séparation de sources, lesdites combinaisons linéaires à coefficients fixes étant déterminées en combinant le post-traitement et le prétraitement.

4. Système selon la revendication 3 caractérisé en ce que les moyens de post-traitement sont tels qu'ils délivrent des estimations des signaux primaires X(t).

5. Système selon les revendications 1 à 4 caractérisé en ce qu'il comprend des moyens (15) de commande qui reçoivent en entrée les seconds signaux (F) à partir desquels ils délivrent au moins une commande (16) pour agir sur au moins une source.

6. Application du système selon une des revendications 1 à 5 au contrôle d'appareils d'émission et/ou de réception de signaux sonores, électriques, électromagnétiques.

7. Application du système selon la revendication 6 pour une commande du son émis par un autoradio ou pour une commande du fonctionnement d'un téléphone mains libres.

**Patentansprüche**

1. Quellencharakterisierungssystem (8), das ausgehend von ersten Signalen E(t), die durch Linearfaltungsmischung von Primärsignalen X(t) aus jeweiligen Primärsignalquellen (5) erzeugt werden, zumindest ein zweites Signal (F) erzeugt, das wenigstens ein jeweiliges Primärsignal X(t) charakterisiert, wobei das System Quellentrennmittel enthält (10),
dadurch gekennzeichnet, dass es vor den Quellentrennmitteln (10) angeordnete Vorbearbeitungsmittel (20) enthält, die die Signale E(t) durch das Bestimmen zumindest einer charakteristischen Größe der Signale E(t) vorbearbeitet, und diese Größe in Form dritter Signale I(t, p) erzeugt wird, die aus Linearkombinationen durch feste oder langsam veränderliche Koeffizienten charakteristischer Größen derselben Art in Bezug auf die Primärsignale X(t) gebildet werden.

2. System nach Anspruch 1, dadurch gekennzeichnet, dass die charakteristische Größe eine durchschnittliche Energie, eine Spektraldichte, eine Autokorrelationsfunktion ist.

3. System nach Anspruch 1 oder 2, dadurch gekennzeichnet, dass es Nachbearbeitungsmittel (30) am Ausgang der Quellentrennmittel (10) zum Nachbearbeiten vierter Signale G(t) aus den Quellentrennmitteln (10) enthält, wobei die Linearkombinationen mit festen Koeffizienten durch Kombinieren der Nachbearbeitung und der Vorbearbeitung bestimmt werden.

4. System nach Anspruch 3, dadurch gekennzeichnet, dass die Nachbearbeitungsmittel zum Erzeugen von Schätzungen der Primärsignale X(t) angepasst sind.

5. System nach Anspruch 1 bis 4, <u>dadurch gekennzeichnet,</u> dass es Steuermittel (15) enthält, die am Eingang zweite Signale (F) empfängt, auf deren Basis sie zumindest einen Befehl (16) zum Beeinflussen zumindest einer Quelle erzeugen.

6. Anwendung des Systems nach einem oder mehreren der Ansprüche 1 bis 5 zum Steuern von Geräten zum Senden und/oder Empfangen elektrischer, akustischer oder elektromagnetischer Signale.

7. Anwendung des Systems nach Anspruch 6 zum Regeln des von einem Autoradio erzeugten Klangs oder zum Steuern des Betriebs eines Freihandstelefons.

**Claims**

1. A source characterization system (8) which, starting from first signals E(t) formed by linear convolutive mixing of primary signals X(t) from respective primary signal sources (5), supplies at least one second signal (F) characterizing at least one respective primary signal X(t), the system comprising source separation means (10), characterized in that it comprises pre-processing means (20) arranged before the source separation means (10), the pre-processing means pre-processing the signals E(t) by determining at least one characteristic variable of the signals E(t), which variable is supplied in the form of third signals I(t, p) formed by linear combinations, by fixed or slowly varying coefficients, of characteristic variables of the same nature related to the primary signals X(t).

2. A system as claimed in Claim 1, characterized in that the characteristic variable is: an average energy, a spectral density, an autocorrelation function.

3. A system as claimed in Claim 1 or 2, characterized in that it comprises post-processing means (30) arranged at the output of the source separation means (10) for post-processing of fourth signals G(t) supplied by the source separation means (10), said linear combinations with fixed coefficients being determined by combining the post-processing and the pre-processing.

4. A system as claimed in Claim 3, characterized in that the post-processing means are adapted to supply estimates of the primary signals X(t).

5. A system as claimed in Claims 1 to 4, characterized in that it comprises control means (15) which at the input receive second signals (F) on the basis of which they supply at least one command (16) for influencing at least one source.

6. An application of the system as claimed in any one of the Claims 1 to 5 for the control of apparatuses for transmitting and/or receiving electric, acoustic or electromagnetic signals.

7. An application of the system as claimed in Claim 6 for controlling the sound produced by a car radio or for controlling the operation of a hands-free telephone.

**FIG.1**

**FIG.2**

**FIG.3**

FIG.4

FIG.5

FIG.6